# EUROPEAN PATENT SPECIFICATION

(11) **EP 1 559 129 B1**
(45) Date of publication and mention of the grant of the patent: **23.03.2022**
(21) Application number: 03810514.4
(22) Date of filing: 04.11.2003
(51) Int. Cl.: H01J 49/48

(54) **CHARGED PARTICLE SPECTROMETER AND DETECTOR THEREFOR**
GELADENES TEILCHENSPEKTROMETER UND DETEKTOR DAFÜR.
SPECTROMETRE DE PARTICULES CHARGEES ET DETECTEUR ASSOCIE

(30) Priority: 05.11.2002 GB 0225791
(43) Date of publication of application: 03.08.2005
(73) Proprietor: Kratos Analytical Limited, Manchester M17 1GP (GB)
(72) Inventor: PAGE, Simon, Charles, Derbyshire SK13 1AX (GB); PARK, Colin, Duncan, Greater Manchester BL8 3JT (GB); HOPPER, Christopher, Michael, Greater Manchester SK7 1EL (GB)
(74) Representative: Mewburn Ellis LLP
(86) International application number: PCT/GB2003/004750
(87) International publication number: WO 2004/042775

(56) References cited:
- EP-A- 1 170 778
- HATFIELD J V ET AL: "An integrated multichannel charged-particle sensing system" SENSORS AND ACTUATORS A, ELSEVIER SEQUOIA S.A., LAUSANNE, CH, vol. 54, no. 1-3, 1 June 1996 (1996-06-01), pages 777-781, XP004077965 ISSN: 0924-4247
- N. GURKER, M. F. EBEL, H. EBEL: "Imaging XPS-A New Technique", SURFACE AND INTERFACE ANALYSIS, vol. 5, no. 1, February 1983 (1983-02), pages 13-19, DOI: 10.1002/sia.740050105
- SOBOTTKA, S.E.; WILLIAMS, M.B: "Delay line readout of microchannel plates", NUCLEAR SCIENCE, IEEE TRANSACTIONS ON, vol. 35, no. 1, February 1988 (1988-02), pages 348-351, XP000253847, DOI: 10.1109/23.12740
- Anonymous: "High performance Imaging XPS - The Sperical Mirror Analyser", , 1 January 1998 (1998-01-01), XP055353287, Retrieved from the Internet: URL:www.supplied_by_applicant.com [retrieved on 2017-03-09]
- Anonymous: "Axis Ultra", , 1 January 1999 (1999-01-01), XP055353306, Retrieved from the Internet: URL:www.supplied_by_applicant.com [retrieved on 2017-03-09]
- C. Pollak ET AL: "Differential Image Distortion Correction", Microscopy and Microanalysis, vol. 7, no. 04, 1 July 2001 (2001-07-01), pages 335-340, XP055424138, ISSN: 1431-9276, DOI: 10.1017/S1431927601010327

## Description

The present invention relates to a charged particle spectrometer and to a method of operation of such a spectrometer. In particular, the present invention relates to a detector for such a spectrometer.

The bulk of the specification describes the application of the invention in a photoelectron spectrometer, but other charged particle instruments would also be suitable. For example, a hemispherical-only analyser system where the input lens system is operated in such a way as to project a line image from the specimen that is then dispersed in the orthogonal direction to generate a 2d image, with one axis being positioned along a line on the sample and the other showing photoelectron energy. Alternatively, the input lens system could be operated to project an angular distribution from the sample as in for example a Thermo VG Scientific Theta Probe.

Also, for example, the invention could be applied to spectrometers using Auger electrons or scattered ions as the analysed charged particles.

Gurker et al, Surface and Interface Analysis, Vol. 5, No. 1, 1983 describes an imaging XPS technique that makes use of the dispersion properties of a spherical condenser-type spectrometer and applies a two-dimensional electron detection device for decoding the energy emission position of an analysed photoelectron. Sobottka et al, IEEE Transactions on Nuclear Science, Vol. 35, No. 1, 1988 describes delay line readout of large diameter microchannel plates.

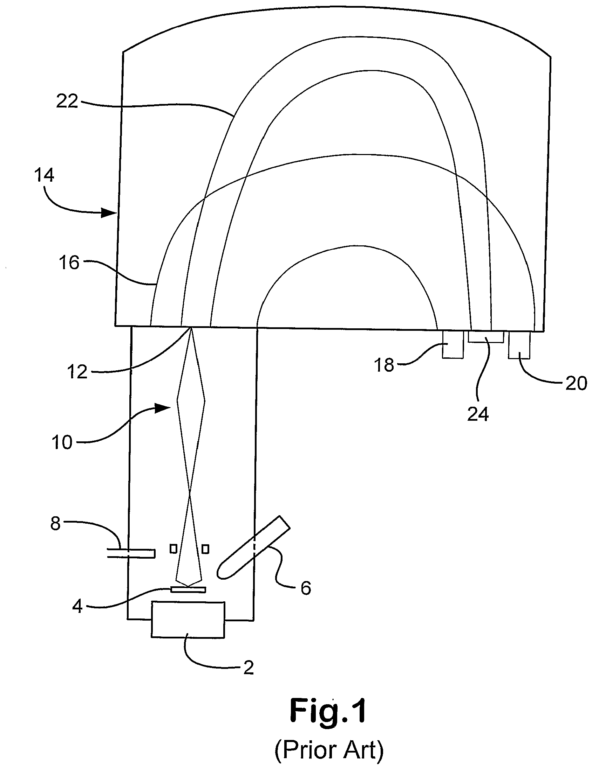

A current photoelectron spectrometer produced by the applicant is shown schematically in Figure 1. The instrument consists of a magnetic lens 2 above which is located the sample 4 to be analysed. In use, the sample 4 is bombarded by X-rays from an X-ray source 6 and the photoelectrons produced are passed through a charge neutraliser 8 and an electrostatic lens system 10 so as to be focused at an entry 12 to an energy analysing section 14.

The instrument has two modes of operation : a spectrum mode for analysing the composition of the surface of the sample 4 ; and an imaging mode for producing a magnified energy selected photoelectron image of the surface of the sample 4. In the spectrum mode, the photoelectrons pass around a hemispherical analyser 16 and are received by a pair of detectors 18,20, which are typically each a set of channeltrons. The two sets of channeltrons enable the instrument to produce an energy spectrum relating to the composition of the surface of the sample 4 from which that composition can be analysed.

In imaging mode, the photoelectrons pass through spherical mirror analyser portion 22 of the energy analysing section 14 and are received by a different detector 24 which is typically a micro channel plate (MCP) detector. Photoelectrons received by the micro channel plate are used to produce further secondary electrons which are then projected on to a phosphorescent screen. The phosphorescent screen can then be viewed by a CCD camera from which an energy analysed photoelectron image of the surface of the sample 4 can be produced. Said image could represent the distribution of a particular element or chemical state of the element.

This instrument has the disadvantage that two types of detectors are required as explained above, one for each mode of operation. The present invention aims to reduce or overcome some or all of the disadvantages associated with prior art instruments.

Accordingly, in a first aspect, the present invention provides a photoelectron spectrometer as set out in claim 1.

The present invention reduces the complexity of the detector system of the prior art instrument. Also the detector can receive photoelectrons over a larger physical area than is the case with the prior art since in the prior art the two types of detector cannot be located in the same physical location and so each detector in use is only covering a part of the detection area.

The detector includes plate means, wherein the plate means is a micro channel plate or includes a plurality of micro channel plates, on to which in use primary electrons are directed in both modes of operation and which emits a plurality of secondary electrons for each primary electron received. The detector also includes first delay line means for using the plurality of secondary electrons to produce a pair of electrical pulses in a delay line from which a signal processing means can calculate the location of the primary electron on the plate means in a first direction. The detector also includes second delay line means for using the plurality of secondary electrons to produce a pair of electrical pulses in a second delay line from which the signal processing means can calculate the location of the primary electron on the plate means in a second direction.

Effectively, this type of detector partly replaces the phosphorescent screen and CCD detector as described in the prior art. This enables the location of each primary electron on the plate means to be determined more accurately.

Preferably the first and second directions are orthogonal e. g. effectively define an X and Y axis on the plate means.

In some embodiments the spectrometer includes second signal processing means (which it may be separate from, or part of the signal processing means mentioned above) for processing the signals received from one or both of the delay lines in order to reduce or eliminate any unwanted signals, such as noise caused by imperfections in the construction of the detector and/or electronic cross talk between the delay lines.

The spectrometer includes control means for controlling its operation and enabling a user to select which of the two modes is operating. Preferably the control means also controls the signal processing means such that when the spectrometer is operating in spectrum mode, the signal processing means utilises signals from only one of the delay line means.

Additionally or alternatively, the control means may also control the signal processing means so that when the spectrometer is operating in image mode the signal processing means utilises signals from both the first and second delay line means and may also include further processing means for increasing the accuracy of the time measurements of the electrical pulses, preferably by stretching the time between each one of a pair of pulses so that the time difference may be more accurately measured.

In a further aspect, the present invention provides a method as set out in claim 8.

An embodiment of the present invention will now be described with reference to the accompanying drawings in which:-
Fig. 1 is a schematic diagram of a prior art photoelectron spectrometer.
Fig. 2 is a schematic diagram of a photoelectron spectrometer according to the present invention.
Fig. 3 is a schematic diagram showing part of a detector according to an embodiment of the present invention.
Fig. 4 is a flow chart showing the operation of a spectrometer according to an embodiment of the present invention.
Fig. 5 is a schematic diagram showing the operation of a detector according to an embodiment of the present invention in spectroscopy or spectrum mode.
Fig. 6 is a schematic diagram showing part of a detector according to an embodiment of the present invention and its operation in imaging mode.
Fig. 7 is a schematic diagram showing a further delay line anode assembly.

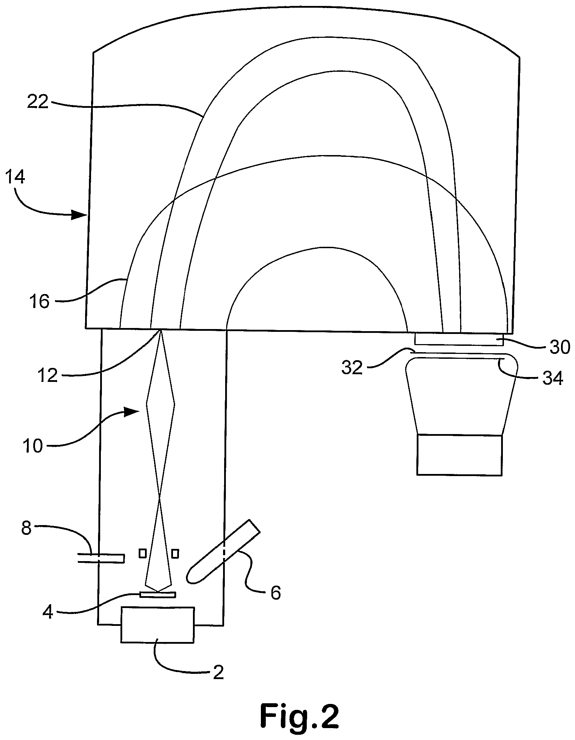

Fig. 2 shows a schematic diagram of an XPS (X-ray photoelectron spectrometer) which in its basic operation is fairly similar to the instrument shown in Fig. 1. Identical reference numerals have been used for those parts of the instrument which are the same. The main differences lie in the detector used.

In Fig. 2, the spectrometer includes a single detector unit 30 which is usable in both modes of operation of the spectrometer - spectrum mode and imaging mode. In some embodiments, the detector plate 30 is a micro channel plate (MCP) and in some other embodiments it may include a plurality of micro channel plates, such as three or more plates.

Arranged adjacent to the detector plate 30 is a pair of delay lines 32, 34, although more or fewer delay lines may be used. The detector plate 30 and the delay lines 32, 34 together make up the detector of this instrument and this detector is usable for both imaging and spectroscopy, unlike the prior art instrument described above.

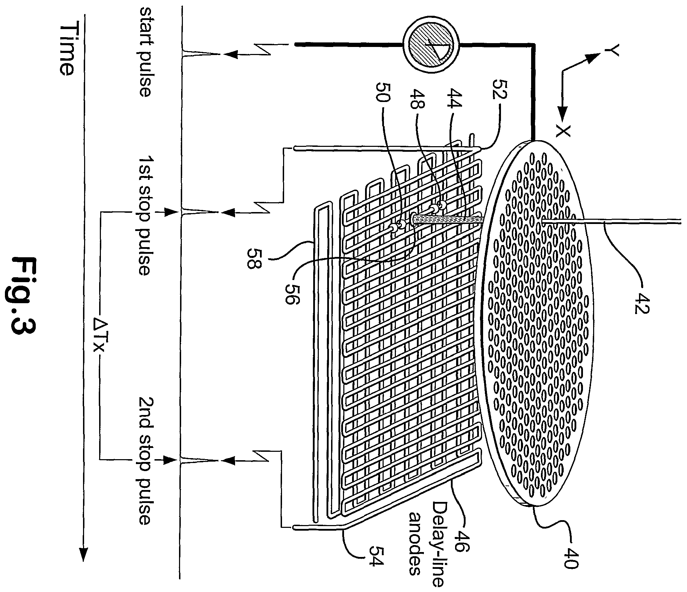

Fig. 3 shows in schematic form the operation of part of the detector. In use, in either mode of operation, primary electrons from the instrument will strike the micro channel plate (MCP) 40. In Fig. 3, a single electron 42 is schematically shown striking the micro channel plate 40. The operation of the detector plate, such as an MCP, is to amplify a single electron by a large factor (e.g. 10⁷) to produce a "shower" 44 of secondary electrons. A delay line 46 is arranged in a suitable position so that the shower 44 of electrons may fall on it or strike it. As shown in this embodiment, the delay line 46 is arranged such that it covers all or substantially all of the area of the detector plate and also preferably such that the line is laid out in a serpentine fashion whereby the elongate parts of the line are parallel or substantially parallel. However, other arrangements of the delay line are possible such as that produced by winding the delay line around a former to produce a helically wound delay line.

In this way, the elongate parts of the delay line 46 may be arranged to lie perpendicular to a chosen axis of the detector plate. In this example, the delay line 46 lies perpendicular to what is shown as the "X" axis and so the delay line is called the "X" delay line.

The function of the delay line 46 is such that the shower of secondary electrons striking it produces a pair of pulses 48, 50 which propagate in respectively different directions along the delay line i.e. one pulse 50 propagates towards a first end 52 and the second pulse 48 propagates towards a second end 54. The ends of the delay line may be connected to signal processing means which receives the pulses 48, 50 and calculates the time difference between their times of receipt, shown schematically in Fig. 3. This time difference enables the point or origin 56 of the shower 44 on the delay line 46 to be calculated, or at least its coordinate in the "X" direction. This correlates to the position at which the primary electron 42 struck the detector plate and so the position of that electron in the "X" direction can be determined.

The detector includes a second delay line which functions as described above but is laid out in a different way. Preferably the second delay line is laid out so that its elongate parts lie perpendicular to a different axis to the "X" axis and more preferably that different axis is orthogonal to the "X" axis e.g. the "Y" axis shown in Fig. 3. In this way, the position of the primary electron 42 may be determined with respect to both axes i.e. its precise location on the detector plate can be known if necessary depending on the mode of operation of the spectrometer. A second delay line 58 is shown in Fig. 3, which lies perpendicular to what is shown as the "Y" axis and so the second delay line is called the "Y" delay line.

Other arrangements of the delay lines are possible, so that the elongate parts of the delay line may be arranged to lie parallel to a chosen axis of the detector plate. For example the elongate parts of an "X" delay line may lie parallel to an "X" axis, and those of a "Y" delay line may lie parallel to a "Y" axis, wherein the "X" delay line enables the coordinate in the "X" direction of a shower of secondary electrons to be calculated, and wherein the "Y" delay line enables the coordinate of the shower in the "Y" direction to be calculated.

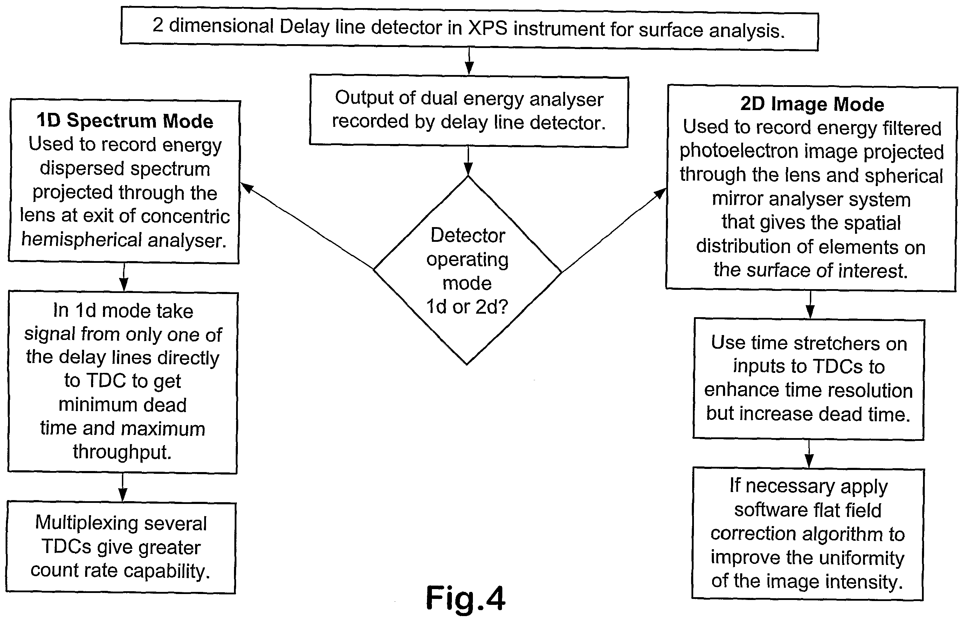

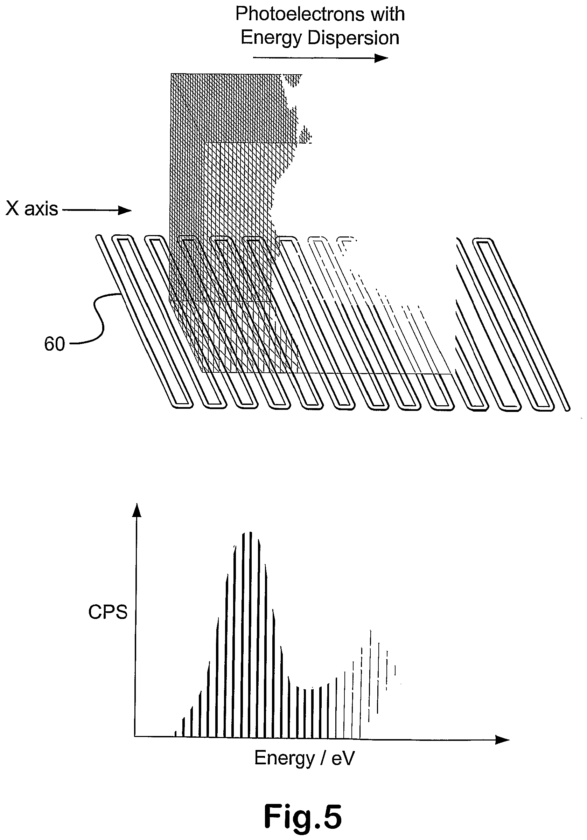

The spectrometer of the present invention may be operable in either one of two different modes as mentioned above - a spectrum mode and an imaging mode. Fig. 4 is a flow chart showing an overview of the operation in both modes. As can be seen, in spectrum mode only readings in only one dimension are required at the detector and so only a portion of the detector may be used. In the detector embodiment utilising a pair of delay lines as described above, this means that the signal processing means may operate on only signals received from one of the delay lines e.g. the "X" delay line 46 as shown in Fig. 3. This is also shown in more detail in Fig. 5.

Fig. 4 also shows the operation of the spectrometer in the imaging mode in which data from two dimensions on the detector is desired. In the detector embodiment described above utilising a pair of delay lines, this means that the outputs of both delay lines will be utilised by the signal processing means as previously described in order to determine the position of the primary electrons on the detector.

Fig. 5 shows schematically how a single delay line 60 is utilised to determine a measurement of the energy of photoelectrons falling on the detector plate. By the nature of the operation of the spectrometer, the further along the "X" axis at which an electron strikes the detector plate, the greater its energy. The delay line 60 is used as previously explained in order to determine the position of electron strike in this "X" direction. In this mode, one or more "time stretchers" may be used in order to enhance the time resolution available for calculating the time difference between pulses in a pair of pulses on each delay line.

In the 1 dimensional single delay line mode because the stretchers may not be needed since there may be no need to enhance the time resolution in this mode. In this mode it is usually more important to maximise the count rate and time stretchers reduce the maximum rate at which events can be processed because they extend the required acquisition time for each event. However in an application where enhanced resolution was required then it would be desirable to use time stretchers.

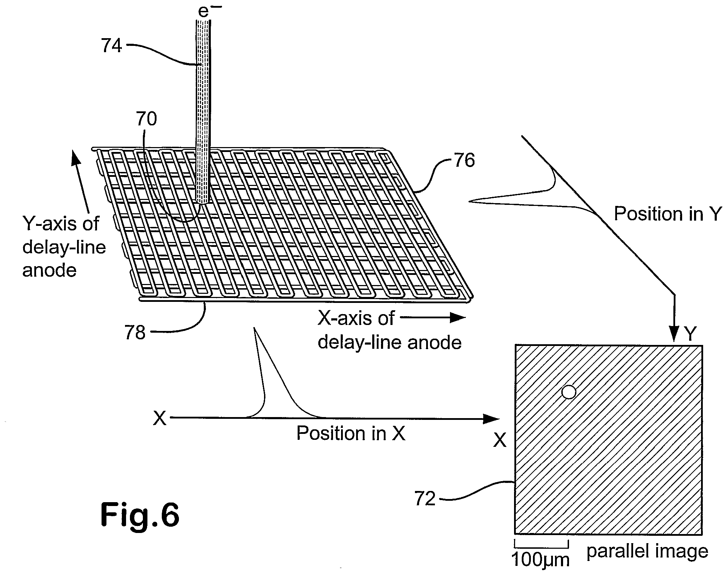

Fig. 6 shows in schematic form the operation of part of the detector in imaging mode. A "shower" 74 of secondary electrons is schematically shown striking the "X" delay line 76, and the "Y" delay line 78. As shown in Fig. 6, the elongate parts of the delay line 76 lie perpendicular to the "X" axis and the elongate parts of the delay line 78 lie perpendicular to the "Y" axis. The shower of secondary electrons 74 produces a pair of pulses in each of the delay lines, which propagate to different ends thereof. The ends of the delay lines may be connected to signal processing means which receives the pulses and calculates the point or origin 70 of the shower on the delay lines. The pulses in the "X" delay line 76 enable the signal processing means to determine the coordinate of the shower 74 on that delay line in the "X" direction, and the pulses in the "Y" delay line 78 enable the signal processing means to determine the coordinate of the shower on the "Y" delay line in the "Y" direction. In this way, a photoelectron image 72 may be produced, which may be a magnified photoelectron image of the surface of the sample in the spectrometer.

A detailed embodiment of the detector electronics will now be described in order to illustrate the operation of both modes:-

The position of an electron impact on the detector is determined using an electronic system.

When an electron hits the front of the detector microchannel plate (MCP) it causes a current pulse from the MCP power supply, as an avalanche of secondary electrons is created. The current pulse may be detected as a voltage pulse across a resistor. Preferably, after amplification, if the pulse exceeds a predefined threshold, an ECL (emitter coupled logic) "start" pulse is generated e.g. using a constant fraction discriminator circuit (CFD). The CFD may be used rather than a simple threshold detector so that the timing of the ECL signal is related to the peak of the voltage pulse, and is independent of the amplitude of the pulse. Other types of logic interface may also be used.

The logic interface is a description of the type of signal processing electronic components. ECL is one type, other types are, for example, Low Voltage Differential Signalling (LVDS) or Low Voltage Positive ECL (LVPECL). The CFD function may be performed by any of the above "logic interface" standards.

The electron cloud leaving the back of the MCP hits the detector wire(s), and respective current pulses propagate to both ends of each detector wire. They are detected e.g. as voltage pulses across resistors, may be amplified and preferably ECL "stop" pulses are generated using CFDs as before. The position of the electron impact on the detector can be determined by timing between the start pulse and the stop pulses, using the position measurement electronics. The difference between the two times for each wire indicates the distance of the impact position from the centre of the wire. The sum of the two times for each wire should be constant, and can be used to detect and reject overlapping impacts.

The position measurement electronics uses e.g. multichannel time-to-digital converter (TDC) integrated circuits to measure the start to stop periods. The stop pulses are enabled into the circuitry by the arrival of a start pulse, to prevent spurious stop pulses causing invalid measurements. A timeout period may be used to reset the circuitry if the stop pulses are not received within the maximum start to stop duration. In this example, valid ECL signals are converted to positive ECL (PECL) and are passed to the TDC inputs. Typically, the TDCs are capable of timing start to stop periods to a 500ps resolution.

As described before, the electronics has two modes of operation: a single dimensional mode and a two dimensional mode. In the single dimensional mode the stop pulses from only one of the detector windings are used. In this mode the typically 500ps resolution of the TDC is sufficient, but a high TDC throughput is desired. This is achieved by multiplexing the start and stop pulses to each of a plurality e.g. four, TDCs in turn. While one device is timing an event, the other device(s) are at different stages of outputting their data to a storage device, e.g. FIFO ("first in first out"), under the control of a hardware state machine. The times are then read from the FIFO into a digital signal processor (DSP) for processing.

In the two dimensional mode the signals from both detector windings are used. In this mode an improved time resolution of typically 50ps is achieved using a time stretching circuit. In one example, a capacitor is charged to a set voltage, prior to operation of the time stretcher circuit. During the start to stop period the capacitor is negatively charged using a fixed constant current, such that the capacitor voltage crosses a threshold just below the initial voltage and continues to increase negatively until the end of the start to stop period. At the end of this period the capacitor is charged positively at a slower rate using a lower constant current, back to the initial voltage. As the capacitor voltage crosses the threshold voltage, a highspeed comparator produces a stop signal, which is passed to the TDC. The amount the time is stretched is determined by the ratio of the discharging current to the charging current.

A lower throughput is required in two-dimensional mode, so the time stretching and the need to read four values out of the TDC rather than two, does not cause a throughput problem. It is also possible to use a single TDC in this mode to eliminate small timing offset differences, caused by manufacturing process differences between TDCs, which may otherwise be experienced.

It is possible that images captured using the delay line detector may contain distortions which appear as faint horizontal and vertical stripes. These are thought to be caused by imperfections in the construction of the detector and/or electronic cross talk between the four stop signals. The invention may use a calibration method which reduces these artefacts.

It is assumed that the stripes are caused by the detector system "moving" electron events slightly from their true positions, depending on their positions in the image and that the error in the horizontal (X) position is independent of the vertical (Y) position and vice versa. Where the image is too bright, the electron events are moved away from each other and where the image is not bright enough, the electron events are moved closer together. Each electron event's position can be corrected independently for X and Y. The calibration consists of two tables containing a position adjustment for each X and Y position.

This procedure causes a slight loss of spatial resolution, but because adjustments are small the loss of resolution is small compared with the instrument resolution. There is no effect on image intensity, since the overall number of electron events remains the same. The calibration tables are generated using a reference image obtained by uniformly illuminating the detector with charged particles.

The procedure for generating the correction table for X positions of an image is described. The procedure for Y is identical. As an example, the image is assumed to be 500 points by 500. The reference image consists of a list of X and Y co-ordinates in the range 0-499. The total number of electron events should be as large as is practical, typically several million.
1. The total number of electron events at each X position (regardless of Y position) is calculated, giving a array of 500 intensities. Each element represents the total intensity of a vertical line of the image.
2. The list of intensities is normalised by dividing each intensity by the average of all intensities and subtracting 1.0. This gives a list of positive and negative values close to zero and represents the error in intensity at each position.
3. The calibration table of position adjustments is derived as follows.
   - The position adjustment for the first point (coordinate value 0) is set to half the intensity error for the first point.
   - For all other points except the last, starting with the 2nd point and working up, the position adjustment is set to the position adjustment of the previous point added to the average intensity error of the previous and current points.
   - For the last point (co-ordinate value 499) , the position adjustment is set to the position adjustment of the previous point (co-ordinate value 498) added to half the intensity error of the last point.

The co-ordinates for each electron event are adjusted by adding the appropriate X position adjustment to the X coordinate and the appropriate Y position adjustment to the Y co-ordinate. This results in co-ordinates which are real numbers, not integers and some co-ordinates may be less than 0.0 or greater than 499.0.

Often, it is necessary to convert the co-ordinates to integers. Because the calibration corrections are typically less than 1.0, simply truncating or rounding the co-ordinates to integers would not give acceptable results. In order to convert the co-ordinates to integers an algorithm is used which rounds up or down at random, with the probability of rounding up depending on the magnitude of the fractional part. This is done by adding a random number between 0.0 and 0.9999999 to each coordinate and then truncating to an integer.

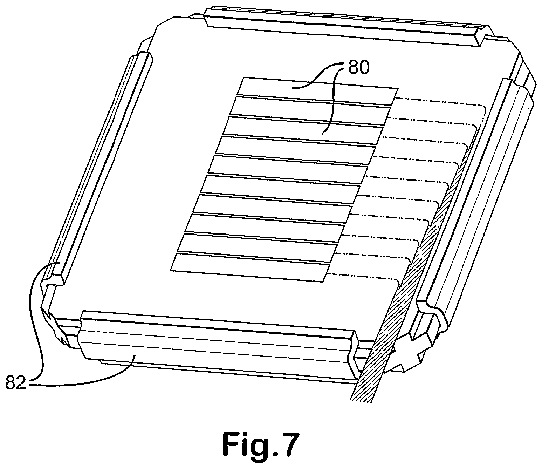

Fig.7 shows a diagram of a delay line anode assembly that includes some additional electrodes. These are flat rectangular collector plates (80) for the electron clouds emitted by the MCPs that can be used instead of (or as well as) one of the delay lines to detect the position of the electron events along one of the directions.

The plates (80) are mounted behind the delay line wires (not shown on this diagram - just the semicircular delay line guides (82) are shown) and the charge emitted by the MCP can be preferentially collected by them by changing the relative potentials on the delay line wires and the discrete anodes. A second array of plates could be added so that each delay line had a corresponding array of plates.

The plates (80) could each be connected to a separate amplifier discriminator counter channels. They have the advantage of being able to record a higher overall count rate from the detector for certain high count rate applications but at reduced positional resolution (the resolution is determined by the size of each plate). The delay line detector system, (timing the pulses at the ends of the line) may be limited to a few million events per second. Some signal sources for the spectrometer can produce signal levels of e.g. 10 times this so in this case this third mode of operation using separate discrete anodes may be appropriate.

The above embodiments are intended to be an example of the present invention and variants and modifications of those embodiments, such as would be readily apparent to the skilled person, are envisaged and may be made without departing from the scope of the present invention.

## Claims

1. A photoelectron spectrometer which is operable in a first mode using a hemispherical analyser (16) to produce an energy spectrum relating to the composition of a sample (4) being analysed, and in a second mode using a spherical mirror analyser (22) to produce a photoelectron image of the surface of the sample (4) being analysed, wherein the spectrometer includes control means for controlling its operation and enabling a user to select which of the two modes is operating, **characterised in that**:
the spectrometer includes a detector (30, 32, 34) which is used to detect photoelectrons produced in both modes of operation;
the detector includes a plate means (40), on to which, in use, primary electrons are directed in both modes of operation, wherein the detector emits a plurality of secondary electrons for each primary electron received;
the detector includes a first delay line means (60, 76) for using the plurality of secondary electrons to produce a pair of electrical pulses in a first delay line from which a signal processing means can calculate the location of the primary electron on the plate means in a first direction; and
the detector includes a second delay line means (78) for using the plurality of secondary electrons to produce a pair of electrical pulses in a second delay line from which the signal processing means can calculate the location of the primary electron on the plate means in a second direction;
wherein the plate means is a micro channel plate or includes a plurality of micro channel plates.

2. A photoelectron spectrometer according to claim 1 wherein the first and second directions are orthogonal.

3. A photoelectron spectrometer according to any one of claims 1 to 2 wherein second signal processing means processes the signals received from one or both of the delay lines to reduce or eliminate any unwanted signals.

4. A photoelectron spectrometer according to any one of claims 1 to 3 wherein the control means also controls the signal processing means such that when the spectrometer is operating in said first mode, the signal processing means utilises signals from only one of the delay line means.

5. A photoelectron spectrometer according to claim 4 wherein the control means also controls the signal processing means so that when the spectrometer is operating in said second mode the signal processing means utilises signals from both the first and second delay line means.

6. A photoelectron spectrometer according to claim 4 or claim 5 wherein the control means includes further processing means for increasing the accuracy of time measurements of the electrical pulses.

7. A photoelectron spectrometer according to claim 6 wherein the further processing means increases said accuracy by stretching the time between each one of a pair of pulses so that the time difference may be more accurately measured.

8. A method of operation of a photoelectron spectrometer according to any one of claims 1 to 7 wherein the method includes the step of selecting which of said first and second modes to use and the detector being operated accordingly.

## Patentansprüche

1. Photoelektronenspektrometer, das in einem ersten Modus unter Verwendung eines Halbkugelanalysators (16) betreibbar ist, um ein Energiespektrum zu erzeugen, das sich auf die Zusammensetzung einer zu analysierenden Probe (4) bezieht, und das in einem zweiten Modus unter Verwendung eines Kugelspiegelanalysators (22) betreibbar ist, um ein Photoelektronenbild der Oberfläche der zu analysierenden Probe (4) zu erzeugen, wobei das Spektrometer Steuermittel zur Steuerung seines Betrieb umfasst und einem Benutzer das Auswählen ermöglicht, welcher der beiden Modi in Betrieb ist, **dadurch gekennzeichnet, dass**:
das Spektrometer einen Detektor (30, 32, 34) umfasst, der verwendet wird, um Photoelektronen, die in beiden Betriebsmodi erzeugt werden, zu detektieren;
der Detektor ein Plattenmittel (40) umfasst, auf das in Verwendung Primärelektronen in beiden Betriebsmodi gerichtet werden, wobei der Detektor eine Vielzahl von Sekundärelektronen für jedes empfangene Primärelektron aussendet;
der Detektor ein erstes Verzögerungsleitungsmittel (60, 76) umfasst, um die Vielzahl von Sekundärelektronen zu verwenden, ein Paar von elektrischen Impulsen in einer ersten Verzögerungsleitung zu erzeugen, aus dem ein Signalverarbeitungsmittel die Position des Primärelektrons auf dem Plattenmittel in einer ersten Richtung berechnen kann; und
der Detektor ein zweites Verzögerungsleitungsmittel (78) umfasst, um die Vielzahl von Sekundärelektronen zu verwenden, ein Paar von elektrischen Impulsen in einer zweiten Verzögerungsleitung zu erzeugen, aus dem das Signalverarbeitungsmittel die Position des Primärelektrons auf dem Plattenmittel in einer zweiten Richtung berechnen kann;
wobei das Plattenmittel eine Mikrokanalplatte ist oder eine Vielzahl von Mikrokanalplatten aufweist.

2. Photoelektronenspektrometer nach Anspruch 1, wobei die erste und die zweite Richtung orthogonal sind.

3. Photoelektronenspektrometer nach einem der Ansprüche 1 bis 2, wobei das zweite Signalverarbeitungsmittel die von einer oder beiden der Verzögerungsleitungen empfangenen Signale verarbeitet, um jegliche unerwünschten Signale zu reduzieren oder zu entfernen.

4. Photoelektronenspektrometer nach einem der Ansprüche 1 bis 3, wobei das Steuermittel auch das Signalverarbeitungsmittel so steuert, dass, wenn das Spektrometer in dem ersten Modus betrieben wird, das Signalverarbeitungsmittel Signale nur von einem der Verzögerungsleitungsmittel verwendet.

5. Photoelektronenspektrometer nach Anspruch 4, wobei das Steuermittel auch das Signalverarbeitungsmittel so steuert, dass, wenn das Spektrometer in dem zweiten Modus betrieben wird, das Signalverarbeitungsmittel Signale von dem ersten sowie von dem zweiten Verzögerungsleitungsmittel verwendet.

6. Photoelektronenspektrometer nach Anspruch 4 oder Anspruch 5, wobei das Steuermittel ein weiteres Verarbeitungsmittel zum Erhöhen der Genauigkeit der Zeitmessungen der elektrischen Impulse umfasst.

7. Photoelektronenspektrometer nach Anspruch 6, wobei das weitere Verarbeitungsmittel die Genauigkeit durch Verlängern der Zeit zwischen jedem Paar von Impulsen so erhöht, dass die Zeitdifferenz genauer gemessen werden kann.

8. Verfahren zum Betrieb eines Photoelektronenspektrometers nach einem der Ansprüche 1 bis 7, wobei das Verfahren den Schritt des Auswählens, welcher von dem ersten und dem zweiten Modus verwendet werden soll, umfasst und wobei der Detektor entsprechend betrieben wird.

## Revendications

1. Spectromètre photoélectronique qui est opérationnel dans un premier mode en utilisant un analyseur hémisphérique (16) pour produire un spectre d'énergie relatif à la composition d'un échantillon (4) étant analysé, et dans un second mode en utilisant un analyseur à miroir sphérique (22) pour produire une image photoélectronique de la surface de l'échantillon (4) étant analysé, dans lequel le spectromètre comprend des moyens de commande pour commander son fonctionnement et permettre à un utilisateur de sélectionner lequel des deux modes fonctionne, **caractérisé en ce que** :
le spectromètre comprend un détecteur (30, 32, 34) qui est utilisé pour détecter des photoélectrons produits dans les deux modes de fonctionnement ;
le détecteur comprend un moyen de plaque (40), sur lequel, en utilisation, des électrons primaires sont dirigés dans les deux modes de fonctionnement, dans lequel le détecteur émet une pluralité d'électrons secondaires pour chaque électron primaire reçu ;
le détecteur comprend un premier moyen de ligne à retard (60, 76) pour utiliser la pluralité d'électrons secondaires afin de produire une paire d'impulsions électriques dans une première ligne à retard à partir de laquelle un moyen de traitement de signal peut calculer l'emplacement de l'électron primaire sur le moyen de plaque dans une première direction ; et
le détecteur comprend un second moyen de ligne à retard (78) pour utiliser la pluralité d'électrons secondaires afin de produire une paire d'impulsions électriques dans une seconde ligne à retard à partir de laquelle le moyen de traitement de signal peut calculer l'emplacement de l'électron primaire sur le moyen de plaque dans une seconde direction ;
dans lequel le moyen de plaque est une plaque à micro-canaux ou comprend une pluralité de plaques à micro-canaux.

2. Spectromètre photoélectronique selon la revendication 1, dans lequel les première et seconde directions sont orthogonales.

3. Spectromètre photoélectronique selon l'une quelconque des revendications 1 à 2, dans lequel un second moyen de traitement de signal traite les signaux reçus de l'une ou des deux lignes à retard afin de réduire ou d'éliminer tout signal indésirable.

4. Spectromètre photoélectronique selon l'une quelconque des revendications 1 à 3, dans lequel le moyen de commande commande également le moyen de traitement de signal de telle sorte que lorsque le spectromètre fonctionne dans ledit premier mode, le moyen de traitement de signal utilise des signaux provenant d'un seul des moyens de ligne à retard.

5. Spectromètre photoélectronique selon la revendication 4, dans lequel le moyen de commande commande également le moyen de traitement de signal de sorte que lorsque le spectromètre fonctionne dans ledit second mode, le moyen de traitement de signal utilise des signaux provenant à la fois des premier et second moyens de ligne à retard.

6. Spectromètre photoélectronique selon la revendication 4 ou la revendication 5, dans lequel le moyen de commande comprend en outre un moyen de traitement pour augmenter la précision de mesures temporelles des impulsions électriques.

7. Spectromètre photoélectronique selon la revendication 6, dans lequel le moyen de traitement supplémentaire augmente ladite précision en étirant le temps entre chacune d'une paire d'impulsions de sorte que la différence de temps peut être mesurée de façon plus précise.

8. Procédé de fonctionnement d'un spectromètre photoélectronique selon l'une quelconque des revendications 1 à 7, dans lequel le procédé comprend l'étape de sélection de celui desdits premier et second modes à utiliser et le détecteur étant actionné en conséquence.
